# EUROPÄISCHE PATENTANMELDUNG

(11) **EP 2 111 050 A2**
(43) Veröffentlichungstag der Anmeldung: **21.10.2009**
(21) Anmeldenummer: 09005480.0
(22) Anmeldetag: 17.04.2009
(51) Int. Cl.: H04N 17/00

(54) **Rundfunk- und/oder Fernsehsignal-Meßgerät**

(30) Priorität: 18.04.2008 ES 200801194
(71) Anmelder: Sistemas Integrados de Servicios de Telecontrol, S.L., 15706 Santiago de Compostela (ES)
(72) Erfinder: Ledo Gaveiro, Jose Luis, 15706 Santiago de Compostela (ES); Rey Juncal, Jose, 15706 Santiago de Compostela (ES); Loyacono Pardo, Gabriel, 15706 Santiago de Compostela (ES); Ucha Cuevas, Miguel Angel, 15706 Santiago de Compostela (ES); Perez Gonzales, Fernando, 15706 Santiago de Compostela (ES); Mosquera Nartallo, Carlos, 15706 Santiago de Compostela (ES); Lopez Valcarce, Roberto, 15706 Santiago de Compostela (ES)
(74) Vertreter: Dosterschill, Peter

(57) **Zusammenfassung**

Die Erfindung betrifft ein Rundfunk- und/oder Fernsehsignal-Meßgerät (E) mit einer Anzeige-Einheit (7) zur Spektraldarstellung von Meßsignalen, insbesondere tragbares Gerät zur Messung von Rundfunk- und/oder Fernsehsignalen in gemeinsamen Telekommunikationsinfrastruktur-Einrichtungen

Erfindungsgemäß ist vorgesehen, dass das Gerät (E) Mittel aufweist, die die Messungen und die Spektraldarstellung mithilfe digitaler Signalverarbeitung ausführen.

## Beschreibung

Die vorliegende Erfindung betrifft ein tragbares Rundfunk- und/oder Fernsehsignal-Meßgerät mit einer Anzeige-Einheit zur Spektraldarstellung der Meßsignale, insbesondere eines von denjenigen, die zur Messung in gemeinsamen Telekommunikationsinfrastruktur-Einrichtungen in Gebrauch sind, nach dem Oberbegriff des Anspruchs 1.

Die tragbaren Geräte, die zur Prüfung der Qualität von TV- und Rundfunksignalen genutzt sind, haben gegenwärtig die Architektur der Spektralanalysatoren mit Frequenzabtastung zur Grundlage.

Die herkömmliche Architektur dieser Baugruppe ist als Superheterodyne-Spektralanalysator bekannt. Die Architektur basiert auf einer Frequenzabtastung mit Bandpassfiltern und ist zunächst mit nur analogen Bauteilen gebaut. Diese Architektur hat sich bis zur Gegenwart mit dem Gebrauch von Abstimmgeräten, Analog-Digital-Umsetzern und Mikroprozessoren fortentwickelt; mit der Einführung von digitalen Bauteilen in die Systeme ist eine große Messunsicherheit, die den analogen Bauteilen eigen ist, aus den Systemen ausgeschlossen, jedoch wurde es noch nicht erreicht, das auf Spektralabtastungsfilterung und Berechnung der Messung Leistung/Frequenz basierende Funktionskonzept zu ändern.

Gegenwärtig nutzen die tragbaren Feldstärkemesser, die zur Prüfung und Messung der gemeinsamen Telekommunikationsinfrastrukturen und die Fernsehsignalmessung in Benutzung sind, die Spektralabtastungsarchitektur für die Spektralanalyse, sowohl im Auffangsystem (Antenne) als auch im Verteilungssystem.

Die Feldstärkemesser, die mit Abtastungsanalysesystemen gebaut sind, führen die Leistungsmessung des in Betracht kommenden HF-Signals durch Herabsetzen des Signals auf Funktionsfrequenz und Durchführen der Bandpassfilterung über RBW-Filter mit unterschiedlichen Grenzfrequenzen (Auflösungsfilter) durch. Die Auflösungsfilter lassen das Signal durch, um die Amplitudenmessung an jedem Frequenzpunkt durchzuführen. Auch wenn dieses Verfahren einen großen Dynamikumfang zulässt, weist es doch den Nachteil auf, dass es unter Nutzung von Leistungsprüfleitungen in jeder RBW nur ein Amplitudendatum für jeden Frequenzpunkt berechnen kann; je nach ausgewähltem SPAN und der RBW muss eine Anzahl von Schritten zum Berechnen und Darstellen des Frequenzspektrums des Signals ausgeführt werden. Wenn man diese Zeitspannen summiert, erhält man die Zeit, die zum Berechnen des Spektrums aufgewendet wurde, in manchen Fällen bis zu mehreren Sekunden. Das Verfahren setzt voraus, dass der Analysator mehrere Abtastungen ausführen kann, ohne dass sich das Signal wesentlich verändert. Wenn das Signal genügend gleichbleibend ist, genügt dieses Verfahren, wenn das Signal jedoch eine Frequenzkomponente aufweist, die veränderlich ist, ist es statistisch wahrscheinlich, dass es verloren geht.

Die Aufgabe der vorliegenden Erfindung ist die Verwirklichung eines tragbaren, batteriebetriebenen Geräts, das Messungen zum Kennzeichnen verschiedener TV-Signalarten (DVBT, DVBC, DVBS und DVBS2) und Spektralanalyse in einer kollektiven Verteilung (gemeinsame Telekommunikationsinfrastrukturen) mithilfe digitaler Signalverarbeitung unter Nutzung einer Architektur ohne Bandpassfilterbank und digitaler Verarbeitung auf ZF-Ebene.

Diese Aufgabe wird mit einem Meßgerät wie in den Ansprüchen definiert gelöst.

Die Erfindung weist vielfältige Vorteile auf.

Ein Beispiel eines tragbaren Rundfunk- und/oder Fernsehsignal-Meßgeräts mit Kapazität zur Spektraldarstellung, insbesondere ein tragbares Gerät zur Messung von Rundfunk- und/oder Fernsehsignalen in gemeinsamen Telekommunikationsinfrastruktur-Einrichtungen, weist gemäß der Erfindung Mittel auf, die die Messungen und die Spektraldarstellung mithilfe digitaler Signalverarbeitung ausführen. Dies weist den Vorteil auf, mit Übergängen des HF-Signals zusammenhängende Veränderungen zu erkennen zu können, da keine Frequenzabtastungen mit Durchlässen des Auflösungsfilters ausgeführt werden müssen, und über eine größere Unabhängigkeit von den analogen Vorrichtungen zu verfügen, die einen klassischen Spektralanalysator mit Abtastung bilden.

In einem anderen Beispiel gemäß der Erfindung sind die Mittel, die die Messungen und die Spektraldarstellung ausführen, durch einen HF-Block, einen Bandpassfilter, einen Analog-Digital-Umsetzer, ein Verarbeitungsmodul, einen Mikroprozessor und einen Speicher gebildet. Die Umsetzung auf das ZF-Band, Filterung und Erkennung weisen digitale Beschaffenheit auf, da das Signal von einem Analog-Digital-Umsetzer gezeigt ist. Die Kennzeichen dieses Systems sind durch die Leistung des digitalen Verarbeitungsblocks und durch die Analog-Digital-Umsetzung, die durch einen Hochleistungs-ADU mit Linearität, großem dynamischen Umfang und geringem Rauschen, mit durch den Verarbeitungsblock bestimmter Sample-Rate, ausgeführt ist, festgelegt.

Die digitale Verarbeitung ermöglicht es, die Spektraldarstellung und die Ausführung des Frequenzleistungsmessungen mit variablen Auflösungsfiltern (RBW), die mathematisch mit den digitalen Verarbeitungsalgorithmen gebaut sind, zu erzielen. Diese Verwirklichung erreicht es, die Geschwindigkeit des Meßvorgangs und die Genauigkeit in den Grenzfrequenzen der RBW-Filter zu erhöhen, wodurch die Streuung vermieden ist, die bei den analogen RBW-Filtern aufgewiesen ist, welche im Spektralabtastsystem der gegenwärtigen Fernsehsignal-Meßgeräten benutzt sind. Dieses System sieht außerdem digitale Videofilter vor, womit eine größere Genauigkeit bei der endgültigen Darstellung der Messung erzielt ist.

Die digitale Beschaffenheit der Auflösungsfilter und Videofilter ermöglicht ihre Modifikation, Mengenzunahme und Änderung von Eigenschaften, ohne eine Bauteilrevision des Instruments vornehmen zu müssen, wodurch ermöglicht ist, das für das Signal, das gemessen werden soll, passende auszuwählen und eine Vielseitigkeit zu bieten, die bei den Feldstärkemessern, die auf Abtastanalysatoren basieren, nicht besteht.

In einem anderen Beispiel der Erfindung weist das Meßgerät ein Batteriesystem auf, das das Gerät versorgt. Dies weist den Vorteil auf, seine Nutzung an Orten zuzulassen, an denen kein Anschluss an das Stromnetz besteht, wie etwa Dächer, Dachterrassen, Türme usw.
Figur 1 zeigt ein Schaubild des Geräts gemäß der Erfindung.
Figur 2 zeigt den HF-Block und den digitalen Verarbeitungsblock des Geräts gemäß der Erfindung im Detail.

Im Folgenden ist auf Grundlage der Figuren ein nicht einschränkendes Beispiel einer Ausführung des Geräts gemäß der Erfindung beschrieben.

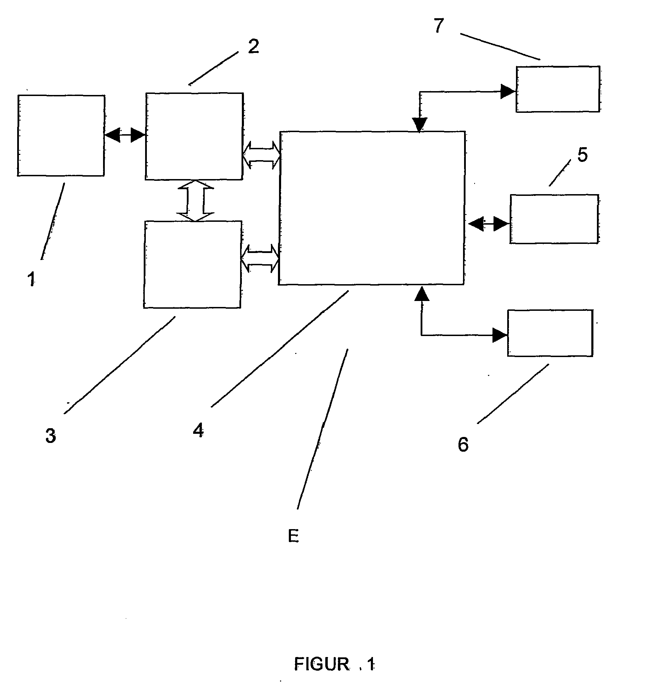

Figur 1 zeigt ein Schaubild des Geräts (E) gemäß der Erfindung. Wie ersichtlich, ist das Gerät (E) durch einen HF-Block (1), einen digitalen Verarbeitungsblock (2), einen Speicher (3), einen Mikroprozessor oder Mikrocontroller (4), eine Benutzeroberfläche (Tastenfeld) (6), eine Sichtanzeige (7) und ein Batteriesystem (5) gebildet. Der Mikroprozessor oder Mikrocontroller (4) ist der Kern des Geräts (E) und für die Verwaltung der anderen Elemente bzw. Gerätekomponenten zuständig. Unter Benutzung eines im Speicher (3) geladenen Programms führt der Mikroprozessor (4) die beschriebenen Funktionen aus und stellt die Ergebnisse auf einer Sichtanzeige (7) mit einer einfachen Benutzeroberfläche (6) dar, das automatisiert das Steuern und Abrufen der Information des Messgeräts (E) zur Darstellung für den Benutzer oder ihre Übertragung an eine andere Vorrichtung ermöglicht.

Ebenso ist der Mikroprozessor (4) für die für den Benutzer transparente Steuerung des HF-Blocks (1) und digitalen Verarbeitungsblocks (2) zuständig. Diese zwei Blöcke, die die Spektralanalysatorbaugruppe ausbilden, sind für das Berechnen der Spektraldarstellung des HF-Signals zuständig, das am Eingang des Geräts (E) erfasst ist. Ein Batteriesystem (5), das vom Mikroprozessor (4) verwaltet ist, versorgt das Gerät (E) mit Strom und lädt autonom von dem Gerät (E) selbst.

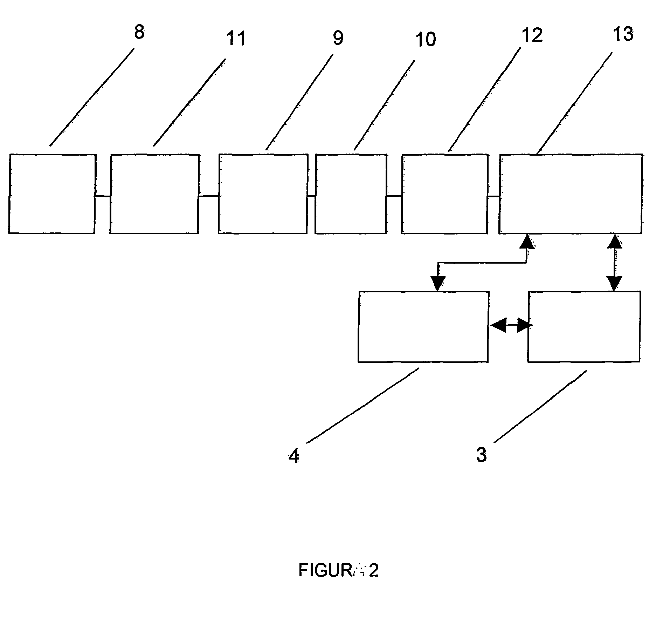

Figur 2 zeigt den HF-Block (1) und den digitalen Verarbeitungsblock (2) des Geräts (E) gemäß der Erfindung im Detail. Wie ersichtlich, ist der HF-Block (1) durch eine Baugruppe von Bandpassfiltern (8) und einen Mischer (9) gebildet. Der digitale Verarbeitungsblock (2) ist durch einen Bandpassfilter (10), ein Verstärkungs-/Dämpfungsnetz (11), einen Analog-Digital-Umsetzer (12) und ein Verarbeitungsmodul (13) gebildet, das durch DSP- und FPGA-Vorrichtungen gebildet.

Die Messung wird derart mit digitalen Signalverarbeitungs- (DPS-) Techniken ausgeführt, dass das Signal nach seiner Bandpassfilterung auf der HF-Bandfrequenz im HF-Block (1) auf ZF abgestimmt und unter Benutzung des digitalen Verarbeitungsblocks (2) in Echtzeit auf Frequenz, Zeit, Modulationsart usw. analysiert wird.

Zur Durchführung der Spektralanalyse ist es notwendig, die Bandbreite, die analysiert werden soll, auf Zwischenfrequenz (ZF) umzulegen; zur Durchführung dieses Vorgangs wird das HF-Eingangssignal mit Filtern (8) mit hohem Abweisungspegel im eliminierten Band und hoher Ebenheit im Durchlassband, die für die verschiedenen Frequenzbänder (HF, VHF, UHF) ausgelegt sind, bandpassgefiltert. Unter Benutzung des Mischers (9) wird das bandgefilterte Signal in der Frequenz auf Zwischenfrequenz verschoben, auf der sie bandpassgefiltert (10) wird. Der Amplitudenpegel des Signals wird mit einem Verstärkungs-/Dämpfungsnetz (11), das vom Mikroprozessor (4) gesteuert ist, auf den am Eingang des Analog-Digital-Umsetzers (12) erforderlichen Pegel angepasst, wo es mit einer Rate von 100 Megasamples pro Sekunde gesampelt wird.

Diese Samples werden im Speicher gespeichert und danach zu ihrer Aufbereitung und Umsetzung in den Frequenzbereich unter Nutzung von Algorithmen der schnellen Fourier-Transformation (FFT), die in einer DSP-Vorrichtung und einer FPGA implementiert sind, welche zum Verarbeitungsmodul (13) gehören, an das Verarbeitungsmodul (13) übertragen. In diesen Elementen wird eine Spektralberechnung entsprechend den vom Mikroprozessor (4) gesendeten Parametern (Anzahl von Punkten, Fensterungsart, Frequenzauflösung, Videofilter usw.) unter Auswahl zwischen der FFT-Art (radix_4, mit 8192 bis 512 Punkten) oder dem Gebrauch von DFT, Fensterart oder Rasterzahl zum Berechnen der Leistungsspektraldichte vorgenommen, wobei der Signalleistungswert für die gesamte Echtzeitbandbreite des Geräts (E) augenblicklich erreicht wird.

### Bezuaszeichenliste

- E: Gerät
- 1: HF-Block
- 2: digitaler Verarbeitungsblock
- 3: Speicher
- 4: Mikroprozessor oder Mikrocontroller
- 5: Batteriesystem
- 6: Benutzeroberfläche
- 7: Sichtanzeige
- 8: Bandpassfilter-Baugruppe
- 9: Mischer
- 10: Bandpassfilter
- 11: Verstärkungs-/Dämpfungsnetz
- 12: Analog-Digital-Umsetzer
- 13: Verarbeitungsmodul

## Patentansprüche

1. Rundfunk- und/oder Fernsehsignal-Meßgerät (E) mit einer Anzeige-Einheit (7) zur Spektraldarstellung von Messsignalen, insbesondere tragbares Gerät zur Messung von Rundfunk- und/oder Fernsehsignalen in gemeinsamen Telekommunikationsinfrastruktur-Einrichtungen,
**dadurch gekennzeichnet,**
**dass** es Mittel aufweist, die die Messungen und die Spektraldarstellung mithilfe digitaler Signalverarbeitung ausführen.

2. Rundfunk- und/oder Fernsehsignal-Meßgerät nach Anspruch 1, **dadurch gekennzeichnet, dass** die Mittel, die die Messungen und die Spektraldarstellung ausführen, eine HF-Einheit (1), einen Bandpassfilter (10), einen Analog-Digital-Umsetzer (12), ein Verarbeitungsmodul (13), einen Mikroprozessor (4) und einen Speicher (3) umfassen.

3. Rundfunk- und/oder Fernsehsignal-Meßgerät nach einem der vorhergehenden Ansprüche, **dadurch gekennzeichnet, dass** es ein Batteriesystem (5) aufweist, das das Gerät versorgt.
